(19) Europäisches Patentamt
European Patent Office
Office européen des brevets

(11) Publication number: **0 168 125**
**B1**

(12) **EUROPEAN PATENT SPECIFICATION**

(45) Date of publication of patent specification: **13.06.90**

(51) Int. Cl.$^5$: **H 01 L 29/40,** H 01 L 23/52

(21) Application number: **85301892.7**

(22) Date of filing: **19.03.85**

(54) **Wiring layers in semiconductor devices.**

(30) Priority: **19.03.84 JP 51205/84**

(43) Date of publication of application:
**15.01.86 Bulletin 86/03**

(45) Publication of the grant of the patent:
**13.06.90 Bulletin 90/24**

(84) Designated Contracting States:
**DE FR GB IT**

(56) References cited:
**US-A-4 141 022**

**PATENT ABSTRACTS OF JAPAN, vol. 6, no. 251, 10th December 1982, page (E-147) (1129) & JP-A-57-149751**

**IBM TECHNICAL DISCLOSURE BULLETIN, vol. 22, no. 2, July 1979, New York, USA; T.M. REITH "Diffusion barrier process", page 558**

(73) Proprietor: **FUJITSU LIMITED**
**1015, Kamikodanaka Nakahara-ku**
**Kawasaki-shi Kanagawa 211 (JP)**

(72) Inventor: **Ito, Takashi**
**408, Noborito Tama-ku**
**Kawasaki-shi Kanagawa 214 (JP)**
Inventor: **Horie, Hiroshi**
**Tanabeso 202 1-4, Katsuse**
**Ebina-shi Kanagawa 243-04 (JP)**
Inventor: **Sugii, Toshihiro**
**Dai 2 Yamato Haitsu 305 312, Shukugawara**
**Tama-ku Kawasaki-shi Kanagawa 214 (JP)**

(74) Representative: **Fane, Christopher Robin King et al**
**HASELTINE LAKE & CO. Hazlitt House 28**
**Southampton Buildings Chancery Lane**
**London, WC2A 1AT (GB)**

(56) References cited:
**APPLIED PHYSICS LETTERS, vol. 32, no. 5, 1st March 1978, New York, USA; T. ITO "Thermally grown silicon nitride films for high-perfomance MNS devices", pages 330-331**

**EP 0 168 125 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to wiring layers in a semiconductor device.

Polycrystalline silicon is often used as the material of electrodes or wiring in the production of a semiconductor device, particularly, an integrated circuit (IC). Since polycrystalline silicon is a semiconductor, it has a high resistivity compared to a metal. To lower the resistivity, impurities such as phosphorous, arsenic, boron, or the like are doped in the polycrystalline silicon. These have not, however, managed to reduce the resistivity to the desired level. The still high resistivity of the polycrystalline silicon therefore causes delays in signal propagation.

Recently, to solve this problem, use has been proposed of a high melting point metal, for example, molybdenum or tungsten, or a silicide thereof. Materials such as molybdenum or tungsten, however, are not very suited to production processes of semiconductor devices such as IC's. For example, when molybdenum or tungsten is deposited on a thin silicon dioxide film and heat-treated at a high temperature, the high melting point metal locally reacts with the silicon dioxide and significantly reduces the breakdown voltage of the silicon dioxide film. Further, when a high concentration doped semiconductor contacts molybdenum or tungsten, the contact resistance is remarkably increased.

Unexamined Japanese Patent Publication (Kokai) No. 56-79450 (filed on December 30, 1979) discloses an electrode or wiring in a semiconductor device formed by placing or burying molybdenum or tungsten at a part of a polycrystalline silicon layer, but the electrode or wiring can still suffer from the problems such as are mentioned above.

IBM Technical Disclosure Bulletin, Vol.22 No.2, July 1979 discloses a Schottky barrier diode which employs a diffusion barrier layer of $Ta_2O_5$ having a thickness of about 5nm between layers of Ta and Al.

According to one aspect of the present invention there is provided a semiconductor device having a contact structure extending over a main surface of the semiconductor body of the device, wherein the contact structure comprises a first conductive layer sandwiched between said main surface and a second conductive layer, there being interposed between the first and second conductive layers an insulating barrier layer;

characterised in that

said contact structure is an electrode wiring layer;

the first conductive layer is made of polysilicon;

the second conductive layer is made of a high melting point metal or silicide thereof; and

the barrier layer is made of silicon nitride and has a thickness such that the occurrence of a reaction between the polysilicon and the high melting point metal or silicide during formation of the latter is prevented, and such as to permit a tunnel current to flow therethrough when the device is in use.

According to a second aspect of the present invention, there is provided a method of forming an electrode wiring layer in a semiconductor device, comprising:

forming a polycrystalline silicon film as a first conductive layer over a substrate;

treating the surface of the polycrystalline silicon film to form a silicon nitride barrier film of a thickness between 1 and 5 nm;

forming, on the silicon nitride film, a film of a high melting point metal or metal silicide as a second conductive layer; and

heat treating the film of high melting point metal or metal silicide so as to reduce the resistivity thereof, whilst the silicon nitride film acts as a barrier preventing the polycrystalline silicon film from reacting with the film of high melting point metal or metal silicide.

An embodiment of the present invention can be made so as to provide a semiconductor device having improved signal propagation.

In a semiconductor device embodying the present invention an electrode or wiring can be produced so as to have a low contact resistance at the interface with the polycrystalline silicon film.

Reference will now be made, by way of example, to the accompanying drawings, wherein:

Figures 1 to 4 show cross-sectional views illustrating a production process for a semiconductor device embodying the present invention;

Figure 5 is a histogram;

Figures 6 to 8 show graphs;

Figures 9A and 9B show I-V characteristics in a conventional polycrystalline silicon gate and in a gate in an embodiment of the present invention, respectively;

Figure 10 shows a cross-sectional view illustrating an ohmic contact electrode in an embodiment of the present invention; and

Figure 11 shows a cross-sectional view illustrating a rectifying contact electrode in an embodiment of the present invention.

Embodiments of the present invention will now be described with reference to the drawings.

Figures 1 to 4 are cross-sectional views illustrating a production process for an embodiment according to the present invention.

The embodiment is described using a metalinsulator-semiconductor (MIS) field-effect-semiconductor device.

As shown in Figure 1, a p-type silicon semiconductor substrate 1 has formed thereon a field insulating film 2, consisting of silicon dioxide, by a selective thermal oxidation process. A gate insulating film 3 is formed by a thermal oxidation process on the surface of an active region of the substrate 1.

As shown in Figure 2, a polycrystalline silicon film 4, having a thickness of about 0.l µm, is formed by a chemical vapor deposition (CVD) process. Phosphorus ions are doped in a high concentration, for example, $10^{20}/cm^3$ or more, into the polycrystalline silicon film 4 by a vapor diffusion process, ion implanting process, or the like.

The surface of the polycrystalline silicon film 4 then has formed thereon a silicon nitride film 5, having a thickness of about 20Å(2 nm), by heat treatment for five minutes at a temperature of 700°C in an atmosphere of pure ammonia gas.

The silicon nitride film 5 may also be formed by a CVD process using, for example, mono-silane ($SiH_4$) and ammonia ($NH_3$) gas or by a nitriding process using energy of ammonia plasma or light irradiation.

This thickness of the silicon nitride film 5 may be from 10 to 50Å(l to 5 nm), allowing the flow of a tunnel current upon application of voltage to the silicon nitride film 5 during operation of the semiconductor device.

The silicon nitride film 5 has formed on it, for example, a molybdenum film having a thickness of about 0.3 µm by a well known sputtering process or CVD process. After that, heat treatment is carried out at a temperature of, for example, about 1000°C to increase the density of the molybdenum film 6 and thus reduce the resistivity of the molybdenum.

During the heat treatment, the silicon nitride film 5 acts as a barrier preventing the polycrystalline silicon film 4 from reacting with the molybdenum film 6, thereby maintaining the low resistivity.

When no silicon nitride film 5 is formed between the polycrystalline silicon film 4 and the molybdenum film 6, molybdenum reacts with the polycrystalline silicon to form molybdenum silicide. Molybdenum has a sheet resistivity of 0.3 Ω/□, while molybdenum silicide has a sheet resistivity of 3 Ω/□. Since impurities doped into the polycrystalline silicon film 4 are not absorbed into the molybdenum film 6 due to the presence of the silicon nitride film 5, the threshold voltage in a gate electrode of an MIS field-effect semiconductor device embodying the present invention can be maintained at substantially the same level as in a conventional silicon gate of an MIS field-effect semiconductor device.

After forming the molybdenum film, as shown in Fig. 3, the molybdenum film 6, silicon nitride film 5, and the polycrystalline silicon film 4 are patterned by reactive ion etching using a conventional lithographic technique to form a two-layer gate electrode consisting of a molybdenum film and a polycrystalline silicon film. After that, required wiring is formed as necessary.

As shown in Fig. 4, arsenic icns (As+) are then injected intc the obtained structure bv ion implantation, while the ion implanted structure is heat-treated so that an n+ type source region 7 and an n+ type drain region 8 are formed in the p-type silicon semiconductor substrate 1.

A phospho-silicate glass (PSG) film 9 is formed on the obtained structure. The PSG film 9 is patterned by a conventional lithographic technique to form electrode contact windows. Aluminum film is formed on the entire surface of the obtained structure by, for example, a sputtering process. The aluminum is patterned by a conventional lithographic technique to form a source electrode 10 and a drain electrode 11. Well-known techniques are applied to the thus obtained structure to form the MIS field effect semiconductor device.

Figure 5 is a histogram illustrating the dielectric strength between a gate electrode and a semiconductor substrate in an embodiment of the present invention.

In Fig. 5, the region designated by reference numeral 12 relates to an MIS field-effect semiconductor device embodying the present invention. In this case, the thickness of the gate insulating film 3 is 200 Å (20 nm). The dielectric strength is 16V to 20V, which is a satisfactory value. The sheet resistivity of the two-layer gate electrode is about 0.5 Ω/□.

On the other hand, the region designated by reference numeral 13 relates to an MIS field-effect semiconductor device which has no silicon nitride film 5 between the polycrystalline silicon film 4 and the molybdenum film 6. In this case, the dielectric strength is remarkably decreased and the sheet resistance becomes about 5 Ω/□.

In the above embodiments, phosphorous ions were doped into the polycrystalline silicon. However, impurities such as boron ions or arsenic ions may also be used. Such impurities may be injected into the silicon substrate from above the molybdenum film 6 because the polycrystalline silicon film acts as a mask.

Further, in the above embodiments, molybdenum was used as the high melting point metal. However, other high melting point metals, such as molybdenum silicide or tungsten (W), chromium (Cr), titanium (Ti), zirconium (Zr), hafnium (Hf), platinum (Pt), palladium (Pd), nickel (Ni), cobalt (Co), iridium (Ir), tantalum (Ta), or silicides thereof may also be used.

According to the present invention, a silicon nitride film acting as a barrier layer is placed between the polycrystalline silicon film and the film consisting of the high melting point metal or silicide thereof. However, the barrier layer is so thin that it has only a small effect on the electrical properties and allows a tunnel current to flow therein.

The electrical properties of an embodiment of the invention are illustrated in Figs. 6 to 9B.

Figure 6 is a graph illustrating the relationship between the threshold voltage and effective channel length.

In Fig. 6, "poly Si gate" shows prior art data, and "MTP gate" shows data of an embodiment of the invention. "MTP" means "Molybdenum Tunnel nitride Polycrystalline silicon".

As shown in Fig. 6, the threshold voltage of an embodiment of the invention is substantially the same as that of the prior art. "Tox" means gate oxide. "Vd" means drain voltage.

Figure 7 is a graph illustrating the relationship between sheet resistance and annealing temperature in an embodiment of the present invention. As shown in Fig. 7, the sheet resistance (Rs) is decreased as the annealing temperature is increased. Although the data is not illustrated in Fig. 7, the sheet resistance in the prior art is increased as the annealing temperature is increased, because of the reaction of the molybdenum or other metal with the silicon dioxide, as explained above.

Figure 8 is a graph illustrating the relationship between gate voltage (Vg) and the ratio ($C/C_{ox}$) of capacitance of an oxide ($C_{ox}$) to the capacitance of an MOS diode embodying the present invention. As shown in Fig. 8, the same curve is followed when the gate voltage is increased and the gate voltage is continuously decreased. Thus, no charge-up phenomenon can be seen between the polycrystalline silicon and molybdenum layers.

Figures 9A and 9B show I-V characteristics in a conventional polycrystalline silicon gate and in a gate (MTP) in an embodiment of the invention, respectively. As shown in Figs. 9A and 9B, the I-V characteristics of the prior art and the present embodiment are substantially the same. The data in Figs. 9A and 9B was obtained using a structure having a tunnel oxide thickness of 25 nm, effective channel length ($L_{eff}$) of 1.3 µm, and effective channel width ($W_{eff}$) of 10 µm.

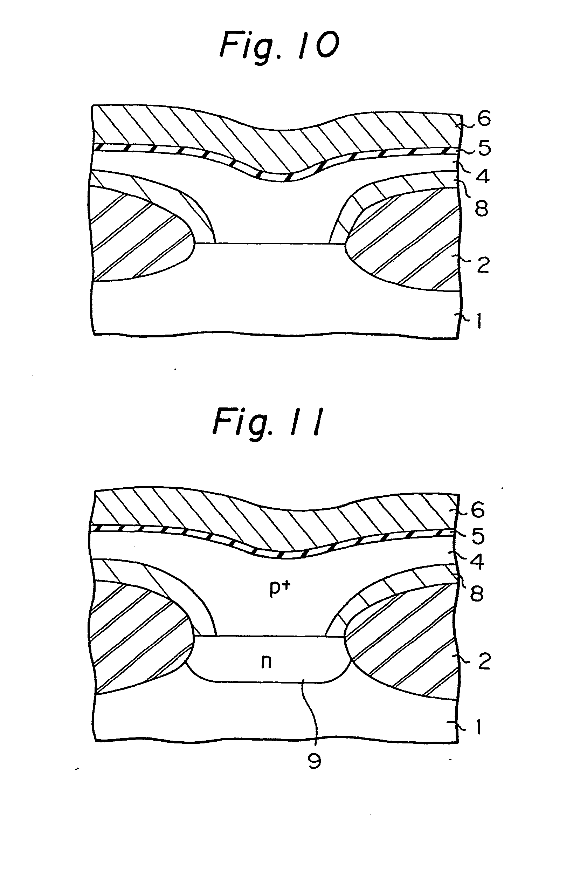

An embodiment of the invention is preferably concerned with an ohmic contact electrode as shown in Fig. 10 and/or a rectifying contact electrode as shown in Fig. 11.

In Fig. 10, the polycrystalline silicon film 4 is contacted with the silicon substrate in ohmic contact.

In Fig. 11, the polycrystalline silicon film 4 doped, for example, with p+ type impurities is contacted with the silicon substrate 1 having, for example, n region 9 in rectifying contact.

**Claims**

1. A semiconductor device having a contact structure extending over a main surface (1) of the semiconductor body of the device, wherein the contact structure comprises a first conductive layer (4) sandwiched between said main surface and a second conductive layer (6), there being interposed between the first and second conductive layers an insulating barrier layer (5);

characterised in that

said contact structure is an electrode wiring layer;

the first conductive layer (4) is made of polysilicon;

the second conductive layer (6) is made of a high melting point metal or silicide thereof; and

the barrier layer (5) is made of silicon nitride and has a thickness such that the occurrence of a reaction between the polysilicon and the high melting point metal or silicide during formation of the latter is prevented, and such as to permit a tunnel current to flow therethrough when the device is in use.

2. A semiconductor device as claimed in claim 1, wherein the thickness of the barrier layer (5) is in the range 1-5 nm

3. A semiconductor device as claimed in claim 2, wherein the thickness of the barrier layer (5) is approximately 2 nm.

4. A semiconductor device as claimed in claim 1, wherein the first conductive layer (4) extends over a gate insulating film (3) which separates the first conductive layer from the main surface (1) at a gate region of the device.

5. A semiconductor device as claimed in any preceding claim, wherein the barrier layer (5) comprises a direct nitride film of a surface region of the first conductive layer.

6. A semiconductor device as claimed in any one of claims 1 to 3 and 5, wherein the first conductive layer (4) contacts an active region of the device.

7. A semiconductor device as claimed in claim 6, wherein said active region consists of a semiconductor region on which an ohmic electrode is arranged and said first conductive layer (4) is in ohmic contact with the active region.

8. A semiconductor device as claimed in claim 6, wherein said active region consists of a semiconductor region on which a rectifying electrode is arranged and said first conductive layer (4) is in rectifying contact with the active region.

9. A semiconductor device as claimed in any preceding claim, wherein the material of the second conductive layer (6) is chosen from the following: molybdenum, tungsten (W), chromium (Cr), titanium (Ti), zirconium (Zr), Hafnium (Hf), platinum (Pt), palladium (Pd), nickel (Ni), cobalt (Co), iridium (Ir), tantalum (Ta), or silicides thereof.

10. A method of forming an electrode wiring layer in a semiconductor device, comprising:

forming a polycrystalline silicon film as a first conductive layer (4) over a substrate;

treating the surface of the polycrystalline silicon film to form a silicon nitride barrier film (5) of a thickness between 1 and 5 nm;

forming, on the silicon nitride film, a film of a high melting point metal or metal silicide as a second conductive layer (6); and

heat treating the film of high melting point metal or metal silicide (6) so as to reduce the resistivity thereof, whilst the silicon nitride film (5) acts as a barrier preventing the polycrystalline silicon film (4) from reacting with the film of high melting point metal or metal silicide.

**Patentansprüche**

1. Halbleitervorrichtung mit einer Kontaktstruktur, die sich über einer Hauptoberfläche (1) eines Halbleiterkörpers der Vorrichtung erstreckt, bei der die Kontaktstruktur eine erste leitende Schicht (4) umfaßt, die sandwichartig zwischen der genannten Hauptoberfläche und einer zweiten leitenden Schicht (6) angeordnet ist, wobei zwischen der ersten und der zweiten leitenden Schicht eine isolierende Sperrschicht (5) angeordnet ist;

dadurch gekennzeichnet, daß

die genannte Kontaktstruktur eine Elektrodenverdrahtungsschicht ist;

die erste leitende Schicht (4) aus Polysilicium hergestellt ist;

die zweite leitende Schicht (6) aus einem Metall mit hohem Schmelzpunkt oder einem Silicid davon hergestellt ist; und

die Sperrschicht (5) aus Siliciumnitrid hergestellt ist und eine solche Dicke hat, daß das Auftreten einer Reaktion zwischen dem Polysilicium und dem Metall mit hohem Schmelzpunkt oder dem Silicid während der Bildung des letzteren verhindert wird, und so, daß ein Tunnelstrom hindurchfließen kann, wenn die Vorrichtung in Betrieb ist.

2. Halbleitervorrichtung nach Anspruch 1, bei der die Dicke der Sperrschicht (5) im Bereich von 1 bis 5 nm beträgt.

3. Halbleitervorrichtung nach Anspruch 2, bei der die Dicke der Sperrschicht (5) etwa 2 nm beträgt.

4. Halbleitervorrichtung nach Anspruch 1, bei der die erste leitende Schicht (4) sich über einem isolierenden Gatefilm (3) erstreckt, welcher die erste leitende Schicht von der Hauptoberfläche (1) bei einem Gatebereich der Vorrichtung trennt.

5. Halbleitervorrichtung nach einem der vorhergehenden Ansprüche, bei der die Sperrschicht (5) einen direkten Nitridfilm auf einem Oberflächenbereich der ersten leitenden Schicht umfaßt.

6. Halbleitervorrichtung nach einem der Ansprüche 1 bis 3 und 5, bei der die erste leitende Schicht (4) einen aktiven Bereich der Vorrichtung kontaktiert.

7. Halbleitervorrichtung nach Anspruch 6, bei der der genannte aktive Bereich aus einem Halbleiterbereich besteht, auf dem eine ohmsche Elektrode angeordnet ist, und die genannte erste leitende Schicht (4) in ohmschem Kontakt mit dem aktiven Bereich steht.

8. Halbleitervorrichtung nach Anspruch 6, bei der der genannte aktive Bereich aus einem Halbleiterbereich besteht, auf dem eine gleichrichtende Elektrode angeordnet ist, und die leitende Schicht (4) in gleichrichtendem Kontakt mit dem aktiven Bereich steht.

9. Halbleitervorrichtung nach einem der vorhergehenden Ansprüche, bei der das Material der zweiten leitenden Schicht (6) ausgewählt ist aus den folgenden: Molybdän, Wolfram (W), Chrom (Cr), Titan (Ti), Zirkon (Zr), Hafnium (Hf), Platin (Pt), Palladium (Pd), Nickel (Ni), Kobalt (Co), Iridium (Ir), Tantal (Ta) oder Siliciden davon.

10. Verfahren zur Bildung einer Elektrodenverdrahtungsschicht in einer Halbleitervorrichtung, mit:

Bilden eines polykristallinen Siliciumfilms als eine erste leitende Schicht (4) über einem Substrat;

Behandeln der Oberfläche des polykristallinen Siliciumfilms, um eine Nitridsperrschicht (5) von einer Dicke zwischen 1 und 5 nm zu bilden;

Bilden eines Films aus Metall oder Metallsilicid mit einem hohen Schmelzpunkt als eine zweite leitende Schicht (6) auf dem Siliciumnitridfilm;

Wärmebehandlung des Films mit hohem Schmelzpunkt aus Metall oder Metallsilicid (6), um so dessen Widerstand zu reduzieren, während der Siliciumnitridfilm (5) als eine Barriere wirkt, welche verhindert, daß der polykristalline Siliciumfilm (4) mit dem Film aus Metall oder Metallsilicid mit hohem Schmelzpunkt reagiert.

**Revendications**

1. Dispositif semi-conducteur comprenant une structure de contact qui s'étend sur une surface principale (1) du corps semi-conducteur du dispositif, dans lequel la structure de contact comporte une première couche conductrice (4) intercalée entre ladite surface principale et une seconde couche conductrice (6), une couche barrière isolante (5) étant intercalée entre la première et la seconde couches conductrices;

caractérisé en ce que

ladite structure de contact est une couche de connexion d'électrode;

la première couche conductrice (4) est faite de polysilicium;

la seconde couche conductrice (6) est faite d'un métal à point de fusion élevé ou d'un de ses siliciures; et

la couche barrière (5) est faite de nitrure de silicium et elle a une épaisseur telle que l'apparition d'une réaction entre le polysilicium et le métal à point de fusion élevé ou son siliciure pendant la formation de ce dernier est évitée, et de manière à permettre qu'un courant de tunnel y circule quand le dispositif est en utilisation.

2. Dispositif semi-conducteur selon la revendication 1, dans lequel l'épaisseur de la couche barrière (5) se situe dans la plage de 1 à 5 nanomètres.

3. Dispositif semi-conducteur selon la revendication 2, dans lequel l'épaisseur de la couche barrière (5) est environ 2 nanomètres.

4. Dispositif semi-conducteur selon la revendication 1, dans lequel la première couche conductrice (4) s'étend sur une pellicule d'isolement de grille (3) qui sépare la première couche conductrice de la surface principale (1) dans une région de grille du dispositif.

5. Dispositif semi-conducteur selon l'une quelconque des revendications précédentes, dans lequel la couche barrière (5) consiste en une pellicule de nitrure directe sur une région de surface de la première couche conductrice.

6. Dispositif semi-conducteur selon l'une quelconque des revendications 1 à 3 et 5, dans lequel la première couche conductrice (4) est en contact avec une région active du dispositif.

7. Dispositif semi-conducteur selon la revendication 6, dans lequel ladite région active consiste en une région semi-conductrice sur laquelle est disposée une électrode ohmique et ladite première couche conductrice (4) est en contact ohmique avec la région active.

8. Dispositif semi-conducteur selon la revendication 6, dans lequel ladite région active consiste en une région semi-conductrice sur laquelle est disposée une électrode redresseuse et ladite première couche conductrice (4) est en contact redresseur avec la région active.

9. Dispositif semi-conducteur selon l'une quelconque des revendications précédentes, dans lequel la matière de la seconde couche conductrice (6) est choisie parmi les suivantes: le molybdène, le tungstène (W), le chrome (Cr), le titane (Ti), le zirconium (Zr), le hafnium (Hf), le platine (Pt), le palladium (Pd), le nickel (Ni), le cobalt (Co), l'irridium (Ir), le tantale (Ta) ou leurs siliciures.

10. Procédé de formation d'une couche de connexion d'électrode dans un dispositif semi-conducteur, consistant:

à former une pellicule de silicium polycristallin comme une première couche conductrice (4) sur un substrat;

à traiter la surface de la pellicule de silicium polycristallin de manière à former une pellicule barrière (5) en nitrure de silicium d'une épaisseur comprise entre 1 à 5 nanomètres;

à former, sur la pellicule de nitrure de silicium, une pellicule d'un métal à point de fusion élevé ou d'un siliciure métallique comme une seconde couche conductrice (6); et

à traiter thermiquement la pellicule de métal à point de fusion élevé ou de siliciure métallique (6) de manière à réduire sa résistivité tandis que la pellicule de nitrure de silicium (5) se comporte comme une barrière évitant que la pellicule de silicium polycristallin (4) réagisse avec la pellicule de métal à point de fusion élevé ou de siliciure métallique.

Fig. 1

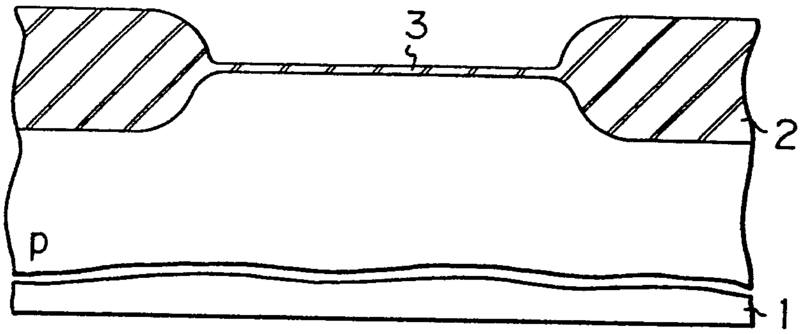


Fig. 2

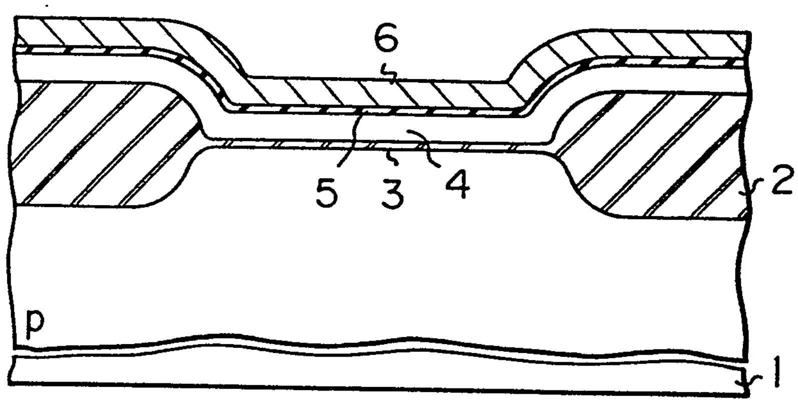

Fig. 3

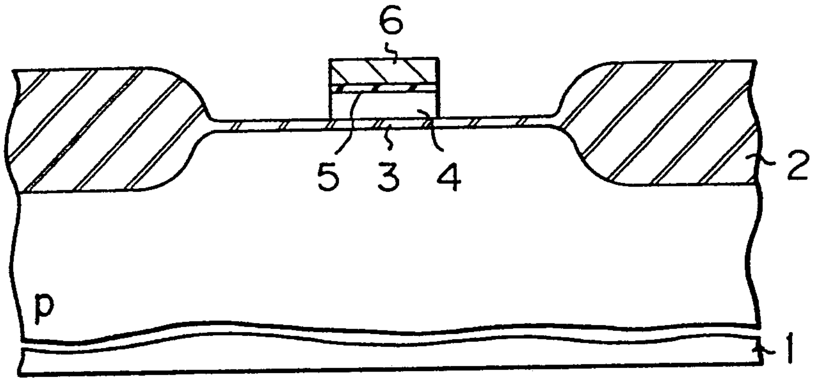


Fig. 4

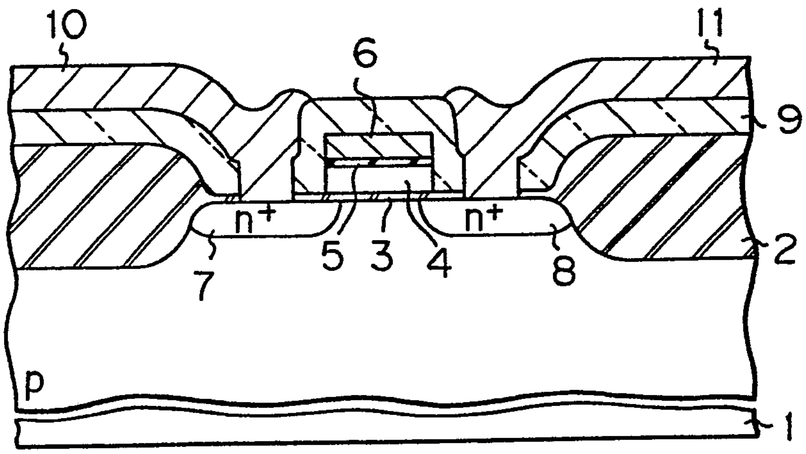

*Fig. 5*

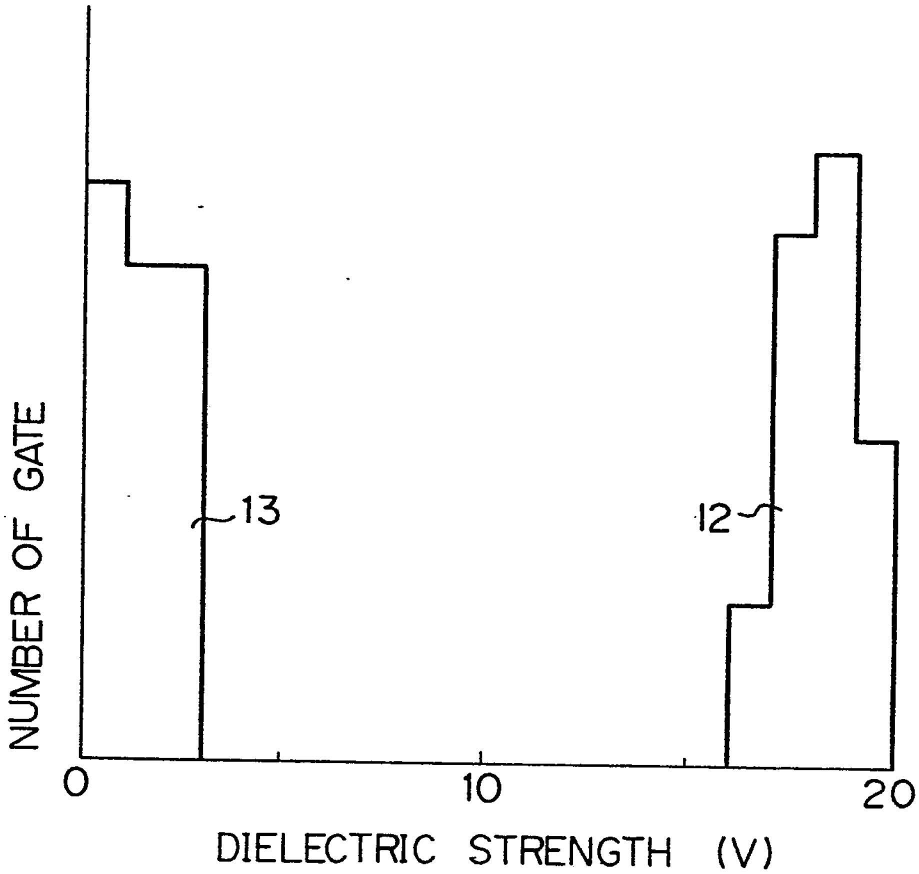

Fig. 6

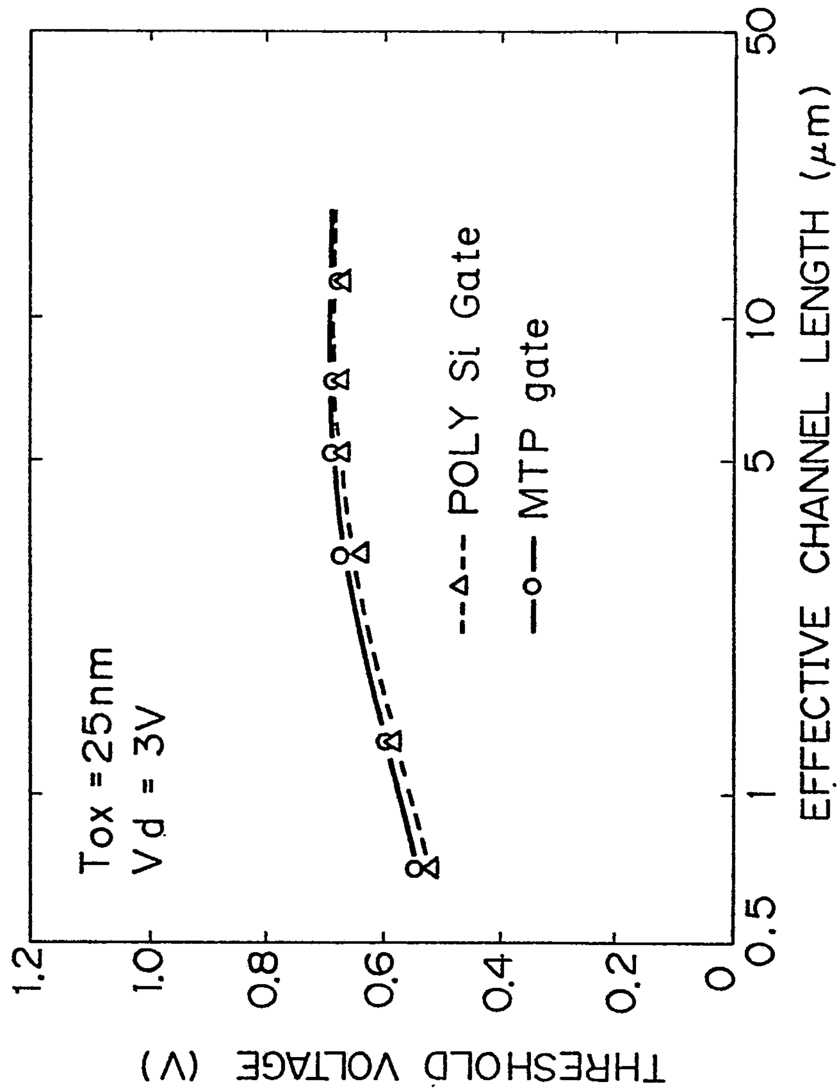
Tox = 25nm
Vd = 3V
POLY Si Gate
MTP gate
THRESHOLD VOLTAGE (V)
0
0.2
0.4
0.6
0.8
1.0
1.2
EFFECTIVE CHANNEL LENGTH (μm)
0.5
1
5
10
50

Fig. 7

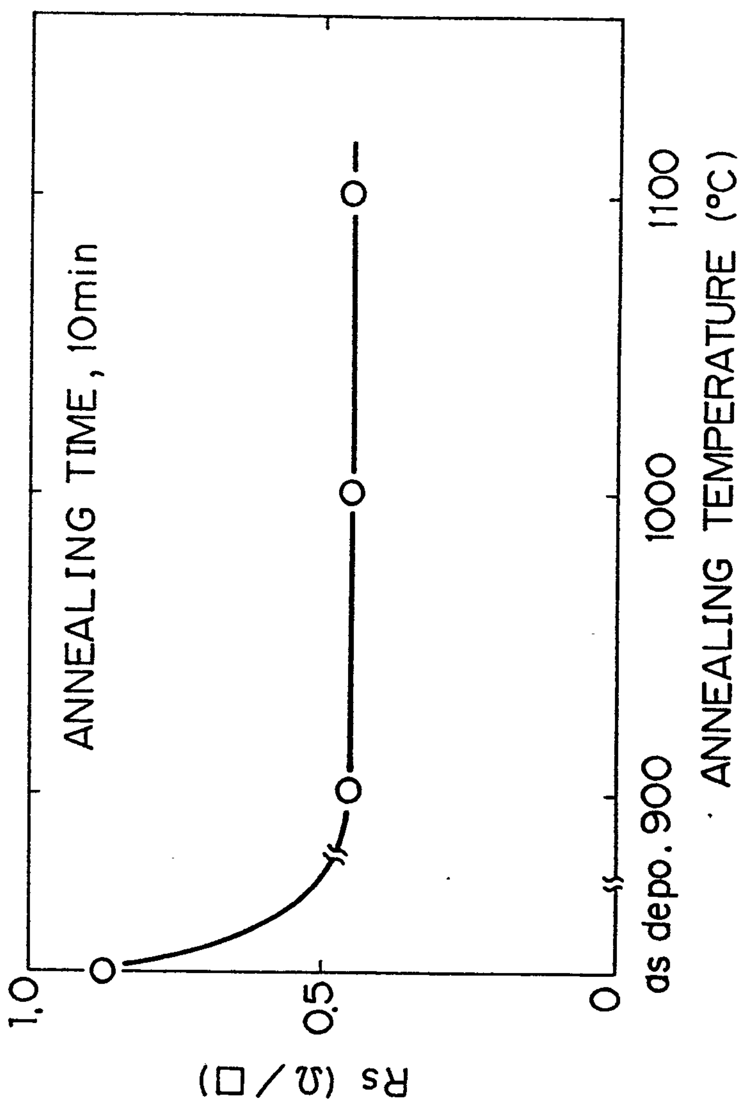
ANNEALING TIME, 10min
Rs (Ω/□)
1.0
0.5
0
as depo.
900
1000
1100
ANNEALING TEMPERATURE (°C)

*Fig. 8*

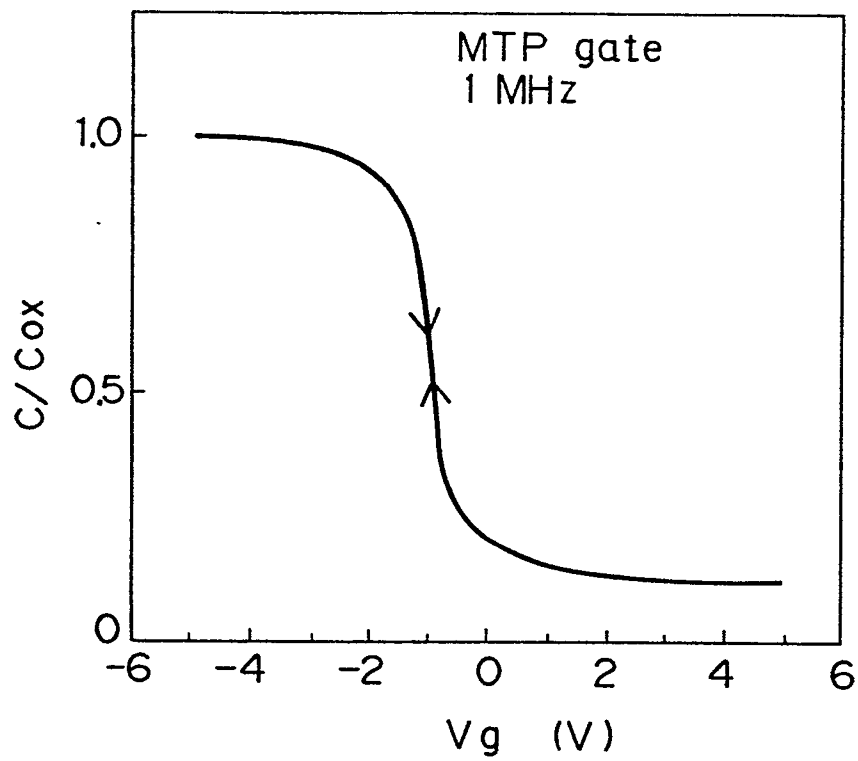

Fig. 9A

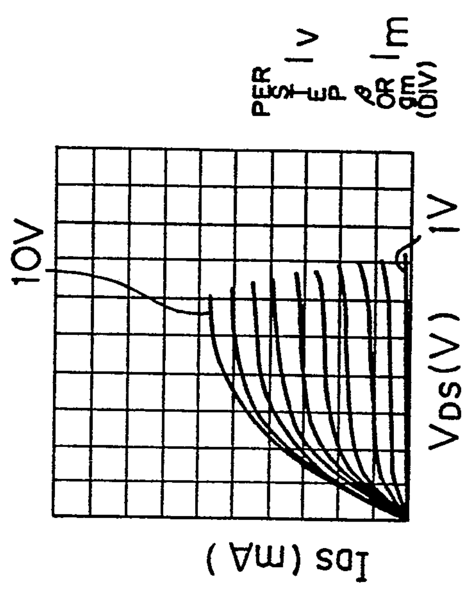


POLY SiGATE

Fig. 9B

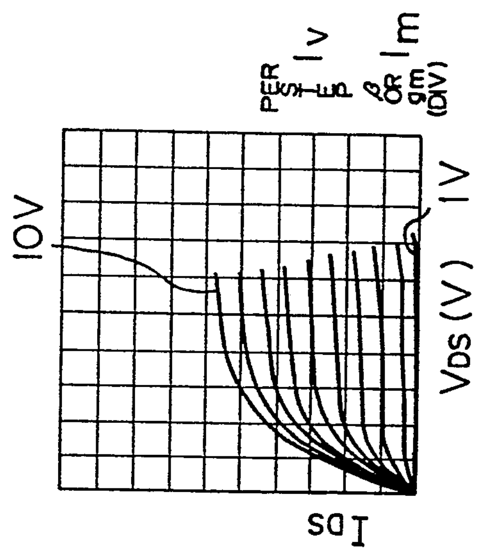


MTP GATE

$T_{ox}$ = 25nm $L_{eff}$ = 1.3 µm $W_{eff}$ = 10 µm

I-V CHARACTERISTICS

Fig. 10

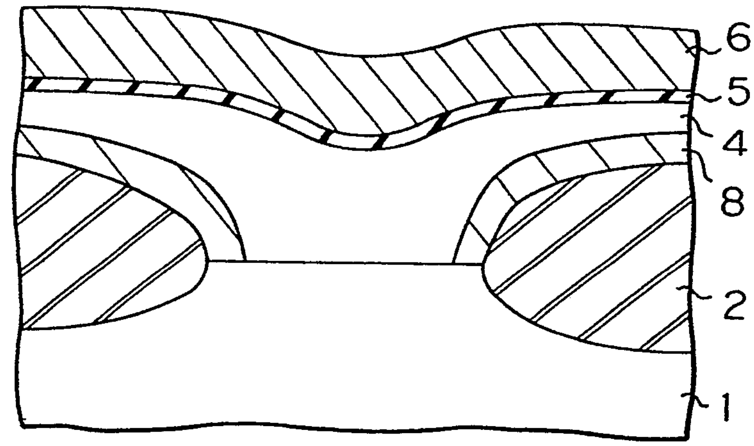


Fig. 11